# EUROPEAN PATENT SPECIFICATION

(11) **EP 4 425 740 B1**
(45) Date of publication and mention of the grant of the patent: **31.12.2025**
(21) Application number: 23205854.5
(22) Date of filing: 25.10.2023
(51) Int. Cl.: H02J 7/00, G01R 31/28, G01R 31/317, H02H 7/18

(54) **CONTROL METHOD OF BATTERY SYSTEM, AND BATTERY CONTROL DEVICE AND BATTERY SYSTEM PERFORMING THE SAME**
STEUERUNGSVERFAHREN EINES BATTERIESYSTEMS SOWIE BATTERIESTEUERUNGSVORRICHTUNG UND BATTERIESYSTEM DAMIT
PROCÉDÉ DE COMMANDE DE SYSTÈME DE BATTERIE, ET DISPOSITIF DE COMMANDE DE BATTERIE ET SYSTÈME DE BATTERIE LE METTANT EN UVRE

(30) Priority: 03.03.2023 KR 20230028668
(43) Date of publication of application: 04.09.2024
(73) Proprietor: Samsung SDI Co., Ltd., Yongin-si, Gyeonggi-do 17084 (KR)
(72) Inventor: CHO, Duckgu, 17084 Yongin-si (KR); EUM, Younghwan, 17084 Yongin-si (KR); LEE, Daehun, 17084 Yongin-si (KR)
(74) Representative: Marks & Clerk LLP

(56) References cited:
- CN-A- 110 945 369
- CN-A- 115 129 107
- US-B2- 11 418 020

## Description

### BACKGROUND OF THE DISCLOSURE

### (a) Field of the Disclosure

The present disclosure relates to a control method of a battery system, and a battery control device and a battery system performing the same.

### (b) Description of the Related Art

An energy storage system (ESS) is a system that increases energy utilization efficiency by storing a significant amount of electrical energy and then supplying the stored electrical energy when the electrical energy is needed.

Typically, the ESS may include a battery system; a battery management system (BMS) that manages the battery system, such as monitoring a voltage, a current, a temperature, and the like of the battery system; a power conversion system (PCS) that performs alternating current (AC)-direct current (DC) conversion and power distribution functions; and an energy management system (EMS) that integrates and controls the entire system of the ESS, such as controlling energy flow of the ESS, collecting and managing information about a state of the ESS. In addition, the battery system may include a plurality of battery racks electrically connected to each other. Each battery rack may include a plurality of battery modules electrically connected to each other, and each battery module may include a plurality of cells electrically connected to each other.

Generally, a test operation is conducted to check whether the ESS operates normally before the ESS is applied to the field. During the test operation, a test is conducted to check whether a protection function of the battery system works normally. During the test of the battery system, a worker arbitrarily changes threshold values of parameters (for example, a voltage, a current, a temperature, and the like) that determine whether a protection function operates in order to prevent damage to the battery system, and then proceeds with the test. In this process, when the threshold values are incorrectly adjusted due to a worker's error and the like, safety problems such as damage to the battery system may occur because the protection function does not operate despite an actual problem occurring in the battery system during the test.

Document US 11 418 020 discloses a battery control device of a battery system including at least one battery module comprising a storage device configured to store a threshold setting value for a parameter; a communication device configured to communicate with a test device; and a controller configured to operate a protection function of the battery system based on the threshold setting value, to change the threshold setting value based on a change value received from the test device if a change of the threshold setting value is requested.

### SUMMARY OF THE DISCLOSURE

The present disclosure has been made in an effort to provide a control method of a battery system, and a battery control device and a battery system performing the same that may prevent safety problems from occurring due to incorrect threshold value adjustment during battery system testing.

An embodiment provides a battery control device of a battery system including at least one battery module, including: a storage device configured to store a safety limit range for a parameter related to a state of the at least one battery module and a threshold setting value for the parameter; a communication device configured to communicate with a test device; and a controller configured to operate a protection function of the battery system based on the threshold setting value, to change the threshold setting value based on a change value received from the test device if a change of the threshold setting value is requested, and to limit the change of the threshold setting value if the change value is out of the safety limit range.

The controller may be further configured to maintain the threshold setting value as a previous value if the change value is out of the safety limit range.

The controller may be further configured to change the threshold setting value to a value corresponding to the safety limit range if the change value is out of the safety limit range.

The controller may be further configured to notify the test device that the change value is not a valid value if the change value is out of the safety limit range.

The controller may be further configured to change an operation mode of the battery system to a test mode when requested to enter the test mode by the test device, and to allow the threshold setting value to be changed only while the battery system operates in the test mode.

If the threshold setting value is changed while the battery system operates in the test mode, the controller may be further configured to control an operation of the protection function based on the changed threshold setting value.

The controller may be further configured to change an operation mode of the battery system to a normal mode if connection between the battery system and the test device is disconnected or if termination of the test mode is requested by the test device.

The controller may be further configured to change the threshold setting value to a default value if the operation mode of the battery system is changed to the normal mode. The default value may be a value outside the safety limit range.

The parameter may be a cell voltage, a module voltage, a current, or a temperature of the at least one battery module. The threshold setting value may be an overvoltage threshold value, a low voltage threshold value, an overcurrent threshold value, or an overtemperature threshold value of the at least one battery module.

If the threshold setting value is the overvoltage threshold value, the default value of the overvoltage threshold value may be higher than an upper voltage limit of the safety limit range.

If the threshold setting value is the low voltage threshold value, the default value of the low voltage threshold value may be lower than a lower voltage limit of the safety limit range.

If the threshold setting value is the overcurrent threshold value, the default value of the overcurrent threshold value may be higher than an upper current limit of the safety limit range.

If the threshold setting value is the overtemperature threshold value, the default value of the overtemperature threshold value may be higher than an upper temperature limit of the safety limit range.

The protection function may include a function of opening a switch connected between the at least one battery module and a load of the battery system.

Another embodiment provides a battery system including: at least one battery module and a battery control device including at least one of the aforementioned features.

Another embodiment provides a control method of a battery system including at least one battery module, including: receiving a change request for a threshold setting value of a parameter related to a state of the at least one battery module; determining whether a change value of the threshold setting value is out of a predetermined safety limit range; if the change value is within the safety limit range, changing the threshold setting value to the change value; if the change value is out of the safety limit range, limiting the change of the threshold setting value; and controlling an operation of a protection function of the battery system based on the threshold setting value.

The limiting may include maintaining the threshold setting value as a previous value if the change value is out of the safety limit range, or changing the threshold setting value to a value corresponding to the safety limit range if the change value is out of the safety limit range.

The control method may further include receiving a change request to a test mode, and changing an operation mode of the battery system to the test mode. The change of the threshold setting value may be allowed only while the battery system operates in the test mode.

The control method may further include changing the operation mode of the battery system to a normal mode if connection between the battery system and the test device is disconnected or if termination of the test mode is requested, and changing the threshold setting value to a default value if the operation mode of the battery system is changed to the normal mode,

The default value may be a value outside the safety limit range.

In the control method, the parameter may be a cell voltage, a module voltage, a current, or a temperature of the at least one battery module. The threshold setting value may be an overvoltage threshold value, a low voltage threshold value, an overcurrent threshold value, or an overtemperature threshold value of the at least one battery module.

In the control method, if the threshold setting value is the overvoltage threshold value, the default value of the overvoltage threshold value may be higher than an upper voltage limit of the safety limit range. If the threshold setting value is the low voltage threshold value, the default value of the low voltage threshold value may be lower than a lower voltage limit of the safety limit range. If the threshold setting value is the overcurrent threshold value, the default value of the overcurrent threshold value may be higher than an upper current limit of the safety limit range. If the threshold setting value is the overtemperature threshold value, the default value of the overtemperature threshold value may be higher than an upper temperature limit of the safety limit range.

At least some of the above and other features of the invention are set out in the claims.

According to the present disclosure, safety problems may be prevented from occurring due to incorrect threshold value adjustment during battery system testing.

### BRIEF DESCRIPTION OF THE DRAWINGS

FIG. 1 illustrates a schematic battery system according to an embodiment.
FIG. 2 illustrates a control method of a battery system according to an embodiment.
FIG. 3 illustrates an energy storage system to which a battery system according to an embodiment is applied.

### DETAILED DESCRIPTION OF THE EMBODIMENTS

Embodiments of the present disclosure will now be described in detail with accompanying drawings. Effects and characteristics of embodiments, and a realization method thereof will now be described in detail with accompanying drawings. In the drawings, same reference numerals indicate same constituent elements, and no repeated descriptions thereof will be provided. The invention is defined by the appended claims.

The embodiments are provided as examples so that the present disclosure may be thorough and complete, and will sufficiently supply aspects and characteristics of the present invention to a person skilled in the art.

Hence, for the purpose of complete understanding on the aspects and the characteristics of the present disclosure, processes, factors, and skills that may not be needed by a person of ordinary skill in the art may not be described. In the drawings, relative sizes of elements, layers, and regions may be exaggerated for clarity.

In the present specification, the term "and/or" includes all or random combinations of a plurality of items that are related and arranged. When the embodiments of the present invention are described, the use of "can" or "may" signifies at least one embodiment of the present invention. In the present specification, a singular term may include a plural form unless stated in another way.

In the present specification, terms including ordinal numbers such as first, second, and the like will be used only to describe various components, and are not to be interpreted as limiting these components. The terms are only used to differentiate one component from other components. For example, a first constituent element could be termed a second constituent element, and similarly, a second constituent element could be termed a first constituent element.

It will be understood that when a constituent element or layer is referred to as being "on," "connected to," or "coupled to" another constituent element or layer, it can be directly on, connected to, or coupled to the other constituent element or layer, or one or more intervening constituent elements or layers may be present. In addition, it will also be understood that when a constituent element or layer is referred to as being "between" two constituent elements or layers, it can be the only constituent element or layer between the two constituent elements or layers, or one or more intervening constituent elements or layers may also be present.

Electrically connecting two constituent elements includes directly connecting two constituent elements, and connecting the same with another constituent element therebetween. The other constituent element may include a switch, a resistor, and a capacitor. When the embodiments are described, an expression of connection signifies electrical connection when an expression of direct connection is not provided.

Hereinafter, a control method of a battery system, and a battery control device and a battery system performing the same according to embodiments will be described in detail with reference to necessary drawings.

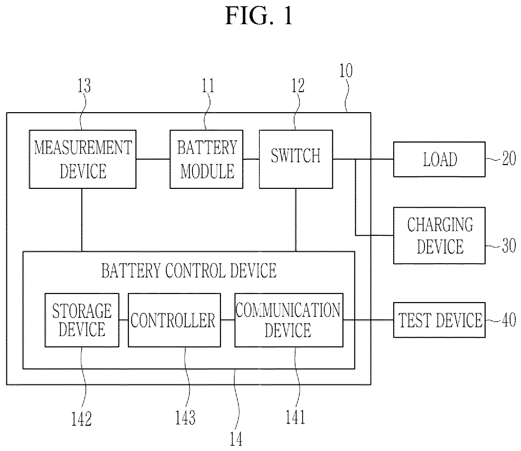

FIG. 1 illustrates a schematic battery system according to an embodiment.

Referring to FIG. 1, a battery system 10 according to an embodiment may include a battery module 11, a switch 12, a measurement device 13, and a battery control device 14.

The battery module 11 may include a plurality of cells (not shown) electrically connected to each other in series or in parallel.

The switch 12 is disposed between the battery module 11 and a load 20/a charging device 30, and it may electrically connect the battery module 11 and the load 20/the charging device 30, or may disconnect electrical connection between the battery module 11 and the load 20/the charging device 30.

The measurement device 13 may measure parameters related to a state of the battery module 11, such as a voltage (a cell voltage, a module voltage, and the like), a current, and a temperature of the battery module 11. The measurement device 13 may include a voltage detection device, a current detection device, a temperature sensor, and the like.

The battery control device 14 may perform a protection function of the battery system 10 based on measured values related to a state of the battery module 11 and their threshold setting values. The battery control device 14 may communicate with a test device 40 to determine to enter a test mode, and may change a threshold setting value within a preset safety limit range based on control information received from the test device 40 upon entering the test mode.

The battery control device 14 may include a communication device 141, a storage device 142, and a controller 143.

The communication device 141 may perform a communication function between the battery control device 14 and an external device. For example, the communication device 141 may communicate with the test device 40 via controller area network (CAN) communication. In addition, for example, the communication device 141 may communicate with an upper controller (not shown) via the CAN communication.

The storage device 142 may store information and data processed by the battery control device 14. For example, the storage device 142 may store a safety limit range of at least one parameter (a voltage, a current, a temperature, and the like) related to the state of the battery module 11. Here, the safety limit range may indicate a range in which a change in the threshold setting value is allowed in the test mode of the battery system 10. In addition, for example, the storage device 142 may store a threshold setting value of at least one parameter related to the state of the battery module 11. Here, the threshold setting value may indicate a value that is a criterion for determining whether to perform the protection function. The safety limit range is a fixed value and may not be changed after it is initially set. On the other hand, the threshold setting value is a changeable value and may be changed if the battery system 10 operates in the test mode.

The controller 143 may control an overall operation of the battery control device 14.

The controller 143 may obtain measurement values of parameters related to the state of the battery module 11, such as a voltage, a current, and a temperature, from the measurement device 13. The controller 143 may compare the obtained measurement value with a corresponding threshold setting value, and determine whether to perform the protection function according to the comparison result. The protection function may include, for example, a function of opening the switch 12 to stop charging or discharging, a function of transmitting a warning message to an upper controller (not shown), and the like.

For example, the controller 143 may open the switch 12 to block charging or discharging of the battery module 11 if a module voltage or at least one cell voltage of the battery module 11 is greater than or equal to an overvoltage threshold or less than or equal to an undervoltage threshold. In addition, for example, the controller 143 may open the switch 12 to block charging or discharging of the battery module 11 if a charging/discharging current of the battery module 11 is equal to or greater than an overcurrent threshold. In addition, for example, the controller 143 may open the switch 12 to block charging or discharging of the battery module 11 if a temperature of the battery module 11 or at least one cell is equal to or higher than an overtemperature threshold.

The controller 143 may communicate with the test device 40 to determine an operation in the test mode. The controller 143 may enter the test mode if a test mode entry is requested by the test device 40. The controller 143 may terminate the test mode and operate in a normal mode if the connection with the test device 40 is disconnected during operation in the test mode or if termination of the test mode is requested by the test device 40.

After entering the test mode, the controller 143 may change the threshold setting value stored in the storage device 142 based on control information received from the test device 40. Before entering the test mode, the threshold setting value stored in the storage device 142 may be set to a default value. The controller 143 may receive a change value of the threshold setting value along with a change request of the threshold setting value from the test device 40, and may change the corresponding threshold setting value stored in the storage device 142 according to the received change value. If the change value received from the test device 40 is out of the safety limit range of the corresponding parameter, the controller 143 may stop changing the threshold setting value and notify the test device 40 that the change value is not a valid value. If the change value received from the test device 40 is out of (e.g. exceeds) the safety limit range of the corresponding parameter, the controller 143 may set the corresponding threshold setting value to a value corresponding to (e.g. within) the safety limit range.

If the test mode ends, the controller 143 may return the changed threshold setting value to a default value. Here, the default value of each threshold setting value is a value actually used to determine the operation of the protection function if the battery system 10 is actually used, and the safety limit range may be set not to deviate from this default value. For example, the default value of the overvoltage threshold value may be higher than an upper voltage limit defined by the safety limit range. In addition, for example, the default value of the low voltage threshold value may be lower than a lower voltage limit defined by the safety limit range. In addition, for example, the default value of the overcurrent threshold value may be higher than an upper current limit value defined by the safety limit range. In addition, for example, the default value of the overtemperature threshold value may be higher than an upper temperature limit defined by the safety limit range.

The controller 143 may be configured as a processor having a physically structured circuit to perform functions expressed by codes or instructions included in a program, such as a microprocessor, a microcontroller, a central processing unit (CPU), a processor core, a multiprocessor, an application-specific integrated circuit (ASIC), and a field programmable gate array (FPGA).

The aforementioned battery control device 14 may be integrated into a battery management system.

Meanwhile, in FIG. 1, a case in which the battery system 10 includes one battery module 11 and one switch 12 connected between the battery module 11 and the load 20/the charging device 30 is shown as an example, but the embodiment is not limited thereto. According to another embodiment, the battery system 10 may include a plurality of battery modules or may include a plurality of switches between the battery module 11 and the load 20/the charging device 30.

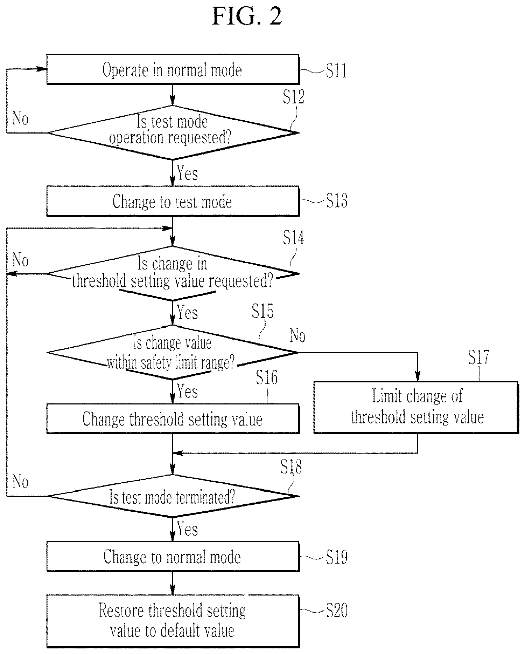

FIG. 2 schematically illustrates a control method of a battery system according to an embodiment. The control method of FIG. 2 may be performed by the battery control device 14 of FIG. 1.

Referring to FIG. 2, the battery control device 14 of the battery system 10 according to the embodiment, if a test mode operation is requested by the test device 40 (S12) while the battery system 10 is operating in the normal mode (S11), may change the operation mode of the battery system 10 to the test mode (S13).

If operating in the test mode, changes in threshold setting values stored in the storage device 142 may be allowed. If a change in the threshold setting value is requested by the test device 40 (S14), the battery control device 14 may determine whether the change value received from the test device 40 is within a corresponding safety limit range (S15).

If the received change value is within the safety limit range, the battery control device 14 may change the corresponding threshold setting value to the received change value (S16). If the threshold setting value is changed, the battery control device 14 may control the operation of the protection function of the battery system 10 based on the changed threshold setting value while the battery system 10 operates in the test mode.

If the received change value is out of the safety limit range, the battery control device 14 may transmit information notifying that the change value is out of the safety limit range to the test device 40, and may limit the change of the corresponding threshold setting value (S17). For example, the battery control device 14 may maintain the threshold setting value requested for change as the previous value without changing it. Said another way, the requested change may not be made and the previous setting may be maintained. In addition, for example, the battery control device 14 may change the threshold setting value requested for change to a value corresponding (e.g. within or at) to the safety limit range.

Thereafter, if the test device 40 is separated from the battery system 10 or if the test mode is terminated according to a request for termination of the test mode from the test device 40 (S18), the battery control device 14 may change the operation mode of the battery system 10 to the normal mode (S19). The battery control device 14 may also automatically restore the threshold setting value changed during the test mode to the default value before the change as the battery system 10 operates in the normal mode (S20).

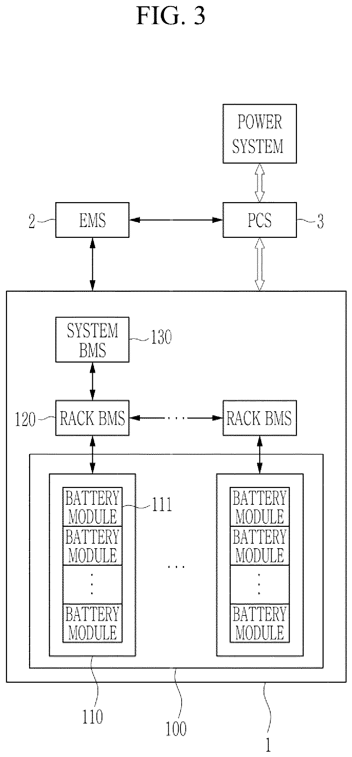

FIG. 3 illustrates an energy storage system (ESS) to which a battery system according to an embodiment is applied.

Referring to FIG. 3, the ESS according to the embodiment may include a battery system 1, an energy management system (EMS) 2, and a power conversion system (PCS) 3.

The battery system 1 may include at least one battery bank 100. Each battery bank 100 may include a plurality of battery racks 110 electrically connected to each other in series or in parallel. In addition, each battery rack 110 may include a plurality of battery modules 111 electrically connected to each other in series or in parallel, and each battery module 111 may include a plurality of battery cells (not shown) electrically connected to each other in series or in parallel.

The battery system 1 may include a rack BMS 120 corresponding to each battery rack 110.

The rack BMS 120 may monitor a state of a corresponding battery rack 110 to control the battery system 1 to operate in an optimal state. To this end, the rack BMS 120 may perform a state (a voltage, a current, a temperature, a state of charge (SOC), a state of health (SOH), and the like) monitoring function, a control function (for example, temperature control and cell balancing control), a protection function (for example, overdischarging, overcharging, overcurrent protection, and the like), and the like for the battery cells configuring the corresponding battery rack 110.

A system BMS 130 may collect data collected by the rack BMS 120 from the rack BMS 120, and may collect and manage the collected data. In addition, if data transmission is requested from an EMS 2, the system BMS 130 may collect and transmit data received from each rack BMS 120 to the EMS 2.

The EMS 2 is an integrated control device that monitors and controls power use of the power system and power supply of the ESS in real time for efficient energy operation of the ESS. The EMS 2 may monitor the state of the entire system (the battery system 1, the PCS 3, or the like) configuring the ESS and control the operation of the ESS.

The PCS 3 may operate as a power conversion device that converts electrical characteristics (a DC, an AC, a voltage, a frequency, and the like) to transmit electrical energy between the battery system 1 and the power system. Generally, electrical energy in the form of DC is used in the battery system 1, and electrical energy in the form of AC is used in the power system. Therefore, the PCS 3 may transmit the electrical energy stored in the battery system 1 to the power system through DC-AC conversion, or may transmit the electrical energy supplied from the power system to the battery system 1 through AC-DC conversion.

In addition to the power conversion and distribution functions described above, the PCS 3 may control electrical quality such as active power and reactive power of the ESS, and may additionally perform a monitoring/control function to monitor the voltage and operation status of the ESS, a grid-connected protection function that protects the power system in case of a power outage, and an independent operation function that operates the ESS by utilizing the battery system 1 even if there is no power.

In the ESS having the above structure, the battery system 1 and the battery module 111 may respectively correspond to the battery system 10 and the battery module 11 described with reference to FIG. 1. In addition, the battery control device 14 of FIG. 1 may be integrated into the rack BMS 120 of the ESS. In addition, the switch 12 and measurement device 13 of FIG. 1 may be mounted in the battery rack 110.

While this disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

### <Description of Symbols>

1: battery system
2: EMS
3: PCS
100: battery bank
110: battery rack
111: battery module
120: rack BMS
130: system BMS
10: battery system
11: battery module
12: switch
13: measurement device
14: battery control device
141: communication device
142: storage device
143: controller

## Claims

1. A battery control device (14) of a battery system (10) including at least one battery module (11), comprising:
a storage device (142) configured to store a safety limit range for a parameter related to a state of the at least one battery module and a threshold setting value for the parameter;
a communication device (141) configured to communicate with a test device (40); and
a controller (143) configured to operate a protection function of the battery system based on the threshold setting value, to change the threshold setting value based on a change value received from the test device if a change of the threshold setting value is requested, and to limit the change of the threshold setting value if the change value is out of the safety limit range.

2. The battery control device of claim 1, wherein:
the controller (143) is further configured to maintain the threshold setting value as a previous value if the change value is out of the safety limit range.

3. The battery control device of claim 1 or 2, wherein:
the controller (143) is further configured to change the threshold setting value to a value corresponding to the safety limit range if the change value is out of the safety limit range.

4. The battery control device of any preceding claim, wherein:
the controller (143) is further configured to notify the test device (40) that the change value is not a valid value if the change value is out of the safety limit range.

5. The battery control device of any preceding claim, wherein:
the controller (143) is further configured to change an operation mode of the battery system (10) to a test mode when requested to enter the test mode by the test device (40), and to allow the threshold setting value to be changed only while the battery system operates in the test mode, and optionally wherein:
if the threshold setting value is changed while the battery system operates in the test mode, the controller is further configured to control an operation of the protection function based on the changed threshold setting value.

6. The battery control device of claim 5, wherein:
the controller (143) is further configured to change an operation mode of the battery system (10) to a normal mode if connection between the battery system and the test device (40) is disconnected or if termination of the test mode is requested by the test device, and optionally wherein the controller is further configured to change the threshold setting value to a default value if the operation mode of the battery system is changed to the normal mode, and the default value is a value outside the safety limit range.

7. The battery control device of claim 6, wherein:
the parameter is a cell voltage, a module voltage, a current, or a temperature of the at least one battery module (11), and
the threshold setting value is an overvoltage threshold value, a low voltage threshold value, an overcurrent threshold value, or an overtemperature threshold value of the at least one battery module.

8. The battery control device of claim 7, wherein:
if the threshold setting value is the overvoltage threshold value, the default value of the overvoltage threshold value is higher than an upper voltage limit of the safety limit range;
if the threshold setting value is the low voltage threshold value, the default value of the low voltage threshold value is lower than a lower voltage limit of the safety limit range;
if the threshold setting value is the overcurrent threshold value, the default value of the overcurrent threshold value is higher than an upper current limit of the safety limit range;
if the threshold setting value is the overtemperature threshold value, the default value of the overtemperature threshold value is higher than an upper temperature limit of the safety limit range.

9. The battery control device of any preceding claim, wherein:
the protection function includes a function of opening a switch (12) connected between the at least one battery module (11) and a load (20) of the battery system (10).

10. A battery system comprising:
at least one battery module (11); and
a battery control device (14) according to any one of claim 1 to claim 9.

11. A control method of a battery system (10) including at least one battery module (11), comprising:
receiving a change request for a threshold setting value of a parameter related to a state of the at least one battery module;
determining whether a change value of the threshold setting value is out of a predetermined safety limit range;
if the change value is within the safety limit range, changing the threshold setting value to the change value;
if the change value is out of the safety limit range, limiting the change of the threshold setting value; and
controlling an operation of a protection function of the battery system based on the threshold setting value.

12. The control method of claim 11, wherein:
the limiting includes:
maintaining the threshold setting value as a previous value if the change value is out of the safety limit range, or
changing the threshold setting value to a value corresponding to the safety limit range if the change value is out of the safety limit range.

13. The control method of claim 11 or 12, further comprising:
receiving a change request to a test mode, and
changing an operation mode of the battery system (10) to the test mode,
wherein the change of the threshold setting value is allowed only while the battery system operates in the test mode.

14. The control method of claim 11, 12 or 13, further comprising:
changing the operation mode of the battery system (10) to a normal mode if connection between the battery system and a test device (40) is disconnected or if termination of the test mode is requested, and
changing the threshold setting value to a default value if the operation mode of the battery system is changed to the normal mode,
wherein the default value is a value outside the safety limit range.

15. The control method of claim 14, wherein:
the parameter is a cell voltage, a module voltage, a current, or a temperature of the at least one battery module (11);
the threshold setting value is an overvoltage threshold value, a low voltage threshold value, an overcurrent threshold value, or an overtemperature threshold value of the at least one battery module;
if the threshold setting value is the overvoltage threshold value, the default value of the overvoltage threshold value is higher than an upper voltage limit of the safety limit range;
if the threshold setting value is the low voltage threshold value, the default value of the low voltage threshold value is lower than a lower voltage limit of the safety limit range;
if the threshold setting value is the overcurrent threshold value, the default value of the overcurrent threshold value is higher than an upper current limit of the safety limit range; and
if the threshold setting value is the overtemperature threshold value, the default value of the overtemperature threshold value is higher than an upper temperature limit of the safety limit range.

## Patentansprüche

1. Batteriesteuerungsvorrichtung (14) eines Batteriesystems (10), das mit mindestens ein Batteriemodul (11) einschließt, umfassend:
eine Speichervorrichtung (142), die dafür konfiguriert ist, einen Sicherheitsgrenzwertbereich für einen Parameter, der sich auf einen Zustand des mindestens einen Batteriemoduls bezieht, und einen Schwellenwert-Einstellwert für den Parameter zu speichern;
eine Kommunikationsvorrichtung (141), die konfiguriert ist, um mit einer Prüfvorrichtung (40) zu kommunizieren und
eine Steuereinheit (143), die dafür konfiguriert ist, eine Schutzfunktion des Batteriesystems basierend auf dem Schwellenwert-Einstellwert zu betreiben, den Schwellenwert-Einstellwert basierend auf einem von der Prüfvorrichtung empfangenen Änderungswert zu ändern, falls eine Änderung des Schwellenwert-Einstellwerts angefordert wird, und die Änderung des Schwellenwert-Einstellwerts zu begrenzen, falls der Änderungswert außerhalb des Sicherheitsgrenzbereichs liegt.

2. Batteriesteuerungsvorrichtung nach Anspruch 1, wobei
die Steuereinheit (143) weiter dafür konfiguriert ist, den Schwellenwert-Einstellwert als einen vorherigen Wert beizubehalten, falls der Änderungswert außerhalb des Sicherheitsgrenzbereichs liegt.

3. Batteriesteuerungsvorrichtung nach Anspruch 1 oder 2, wobei
die Steuereinheit (143) weiter dafür konfiguriert ist, den Schwellenwert-Einstellwert auf einen Wert zu ändern, der dem Sicherheitsgrenzbereich entspricht, falls der Änderungswert außerhalb des Sicherheitsgrenzbereichs liegt.

4. Batteriesteuerungsvorrichtung nach einem vorstehenden Anspruch, wobei:
die Steuereinheit (143) weiter dafür konfiguriert ist, die Prüfvorrichtung (40) zu benachrichtigen, dass der Änderungswert kein gültiger Wert ist, falls der Änderungswert außerhalb des Sicherheitsgrenzbereichs liegt.

5. Batteriesteuerungsvorrichtung nach einem vorstehenden Anspruch, wobei:
die Steuereinheit (143) weiter dafür konfiguriert ist, einen Betriebsmodus des Batteriesystems (10) zu einem Prüfmodus zu ändern, wenn es von der Prüfvorrichtung (40) dazu aufgefordert wird, in den Prüfmodus einzutreten, und eine Änderung des Schwellenwert-Einstellwerts nur zuzulassen, während das Batteriesystem im Prüfmodus arbeitet, und wahlweise, wobei:
falls der Schwellenwert-Einstellwert geändert wird, während das Batteriesystem im Prüfmodus arbeitet, die Steuereinheit weiter dafür konfiguriert ist, einen Betrieb der Schutzfunktion basierend auf dem geänderten Schwellenwert-Einstellwert zu steuern.

6. Batteriesteuerungsvorrichtung nach Anspruch 5, wobei:
die Steuereinheit (143) weiter dafür konfiguriert ist, einen Betriebsmodus des Batteriesystems (10) zu einem Normalmodus zu ändern, falls die Verbindung zwischen dem Batteriesystem und der Prüfvorrichtung (40) getrennt ist oder falls die Beendigung des Prüfmodus durch die Prüfvorrichtung angefordert wird, und wahlweise, wobei die Steuereinheit weiter dafür konfiguriert ist, den Schwellenwert-Einstellwert auf einen Standardwert zu ändern, falls der Betriebsmodus des Batteriesystems zu dem Normalmodus geändert wird und der Standardwert ein Wert außerhalb des Sicherheitsgrenzbereichs ist.

7. Batteriesteuerungsvorrichtung nach Anspruch 6, wobei:
der Parameter eine Zellspannung, eine Modulspannung, ein Strom oder eine Temperatur des mindestens einen Batteriemoduls (11) ist und
der Schwellenwert-Einstellwert ein Überspannungsschwellenwert, ein Unterspannungsschwellenwert, ein Überstromschwellenwert oder ein Übertemperaturschwellenwert des mindestens einen Batteriemoduls ist.

8. Batteriesteuerungsvorrichtung nach Anspruch 7, wobei
falls der Schwellenwert-Einstellwert der Überspannungsschwellenwert ist, ist der Standardwert des Überspannungsschwellenwerts höher als eine obere Spannungsgrenze des Sicherheitsgrenzwertbereichs;
falls der Schwellenwert-Einstellwert der Unterspannungsschwellenwert ist, ist der Standardwert des Unterspannungsschwellenwerts niedriger als eine untere Spannungsgrenze des Sicherheitsgrenzwertbereichs;
falls der Schwellenwert der Überstromschwellenwert ist, ist der Standardwert des Überstromschwellenwerts höher als eine obere Stromgrenze des Sicherheitsgrenzbereichs;
falls der Schwellenwert-Einstellwert der Übertemperaturschwellenwert ist, ist der Standardwert des Übertemperaturschwellenwerts höher als eine obere Temperaturgrenze des Sicherheitsgrenzwertbereichs.

9. Batteriesteuerungsvorrichtung nach einem vorstehenden Anspruch, wobei:
die Schutzfunktion eine Funktion zum Öffnen eines Schalters (12) einschließt, der zwischen dem mindestens einen Batteriemodul (11) und einer Last (20) des Batteriesystems (10) angeschlossen ist.

10. Batteriesystem, umfassend:
mindestens ein Batteriemodul (11); und
eine Batteriesteuerungsvorrichtung (14) nach einem der Ansprüche 1 bis 9.

11. Steuerungsverfahren für ein Batteriesystem (10), das mindestens ein Batteriemodul (11) einschließt, umfassend:
Empfangen einer Änderungsanforderung für einen Schwellenwert-Einstellwert eines Parameters, der sich auf einen Zustand des mindestens einen Batteriemoduls bezieht;
Feststellen, ob ein Änderungswert des Schwellenwert-Einstellwerts außerhalb eines vorgegebenen Sicherheitsgrenzbereichs liegt;
falls der Änderungswert innerhalb des Sicherheitsgrenzbereichs liegt, Ändern des Schwellenwert-Einstellwerts auf den Änderungswert;
falls der Änderungswert außerhalb des Sicherheitsgrenzbereichs liegt, Begrenzen der Änderung des Schwellenwert-Einstellwerts; und
Steuern eines Betriebs einer Schutzfunktion des Batteriesystems basierend auf dem Schwellenwert-Einstellwert.

12. Steuerungsverfahren nach Anspruch 11, wobei:
die Begrenzung Folgendes einschließt:
Beibehalten des Schwellenwert-Einstellwerts als vorheriger Wert, falls der Änderungswert außerhalb des Sicherheitsgrenzbereichs liegt, oder
Ändern des Schwellenwert-Einstellwerts auf einen Wert, der dem Sicherheitsgrenzbereich entspricht, falls der Änderungswert außerhalb des Sicherheitsgrenzbereichs liegt.

13. Steuerungsverfahren nach Anspruch 11 oder 12, weiter umfassend:
Empfangen einer Änderungsanforderung zu einem Prüfmodus und
Ändern eines Betriebsmodus des Batteriesystems (10) zu dem Prüfmodus, wobei die Änderung des Schwellenwert-Einstellwerts nur zulässig ist, während das Batteriesystem im Prüfmodus arbeitet.

14. Steuerungsverfahren nach Anspruch 11, 12 oder 13, weiter umfassend:
Ändern des Betriebsmodus des Batteriesystems (10) zu einem Normalmodus, falls die Verbindung zwischen dem Batteriesystem und einer Prüfvorrichtung (40) getrennt wird oder falls die Beendigung des Prüfmodus angefordert wird, und
Ändern des Schwellenwert-Einstellwerts auf einen Standardwert, falls der Betriebsmodus des Batteriesystems zum Normalmodus geändert wird,
wobei der Standardwert ein Wert außerhalb des Sicherheitsgrenzbereichs ist.

15. Steuerungsverfahren nach Anspruch 14, wobei:
der Parameter eine Zellspannung, eine Modulspannung, ein Strom oder eine Temperatur des mindestens einen Batteriemoduls (11) ist;
der Schwellenwert-Einstellwert ein Überspannungsschwellenwert, ein Unterspannungsschwellenwert, ein Überstromschwellenwert oder ein Übertemperaturschwellenwert des mindestens einen Batteriemoduls ist;
falls der Schwellenwert-Einstellwert der Überspannungsschwellenwert ist, ist der Standardwert des Überspannungsschwellenwerts höher als eine obere Spannungsgrenze des Sicherheitsgrenzwertbereichs;
falls der Schwellenwert-Einstellwert der Unterspannungsschwellenwert ist, ist der Standardwert des Unterspannungsschwellenwerts niedriger als eine untere Spannungsgrenze des Sicherheitsgrenzwertbereichs;
falls der Schwellenwert-Einstellwert der Überstromschwellenwert ist, ist der Standardwert des Überstromschwellenwerts höher ist eine obere Stromgrenze des Sicherheitsgrenzwertbereichs; und
falls der Schwellenwert-Einstellwert der Übertemperaturschwellenwert ist, ist der Standardwert des Übertemperaturschwellenwerts höher als eine obere Temperaturgrenze des Sicherheitsgrenzwertbereichs.

## Revendications

1. Dispositif de commande de batterie (14) d'un système de batterie (10) incluant au moins un module de batterie (11), comprenant :
un dispositif de stockage (142) configuré pour stocker une plage de limite de sécurité pour un paramètre lié à un état de l'au moins un module de batterie et une valeur de réglage seuil pour le paramètre ;
un dispositif de communication (141) configuré pour communiquer avec un dispositif de test (40) ; et
un dispositif de commande (143) configuré pour faire fonctionner une fonction de protection du système de batterie sur la base de la valeur de réglage seuil, pour changer la valeur de réglage seuil sur la base d'une valeur de changement reçue du dispositif de test si un changement de la valeur de réglage seuil est demandé, et pour limiter le changement de la valeur de réglage seuil si la valeur de changement est hors de la plage de limite de sécurité.

2. Dispositif de commande de batterie selon la revendication 1, dans lequel :
le dispositif de commande (143) est en outre configuré pour maintenir la valeur de réglage seuil comme valeur précédente si la valeur de changement est hors de la plage de limite de sécurité.

3. Dispositif de commande de batterie selon la revendication 1 ou 2, dans lequel :
le dispositif de commande (143) est en outre configuré pour changer la valeur de réglage seuil vers une valeur correspondant à la plage de limite de sécurité si la valeur de changement est hors de la plage de limite de sécurité.

4. Dispositif de commande selon une quelconque revendication précédente, dans lequel :
le dispositif de commande (143) est en outre configuré pour notifier au dispositif de test (40) que la valeur de changement n'est pas une valeur valide si la valeur de changement est hors de la plage de limite de sécurité.

5. Dispositif de commande selon une quelconque revendication précédente, dans lequel :
le dispositif de commande (143) est en outre configuré pour changer un mode de fonctionnement du
système de batterie (10) en un mode de test lorsque le dispositif de test (40) lui demande d'entrer en mode de test, et pour permettre le changement de la valeur de réglage seuil uniquement lorsque le système de batterie fonctionne en mode de test, et facultativement dans lequel :
si la valeur de réglage seuil est changée pendant que le système de batterie fonctionne en mode de test, le dispositif de commande est en outre configuré pour commander un fonctionnement de la fonction de protection sur la base de la valeur de réglage seuil changée.

6. Dispositif de commande de batterie selon la revendication 5, dans lequel :
le dispositif de commande (143) est en outre configuré pour changer un mode de fonctionnement du système de batterie (10) en un mode normal si la connexion entre le système de batterie et le dispositif de test (40) est déconnectée ou si la fin du mode de test est demandée par le dispositif de test, et facultativement dans lequel le dispositif de commande est en outre configuré pour changer la valeur de réglage seuil vers une valeur par défaut si le mode de fonctionnement du système de batterie est changé vers le mode normal, et la valeur par défaut est une valeur à l'extérieur de la plage de limite de sécurité.

7. Dispositif de commande de batterie selon la revendication 6, dans lequel :
le paramètre est une tension de cellule, une tension de module, un courant ou une température de l'au moins un module de batterie (11), et
la valeur de réglage seuil est une valeur seuil de surtension, une valeur seuil de basse tension, une valeur seuil de surintensité ou une valeur seuil de surtempérature de l'au moins un module de batterie.

8. Dispositif de commande de batterie selon la revendication 7, dans lequel :
si la valeur de réglage seuil est la valeur seuil de surtension, la valeur par défaut de la valeur seuil de surtension est supérieure à une limite de tension supérieure de la plage de limite de sécurité ;
si la valeur de réglage seuil est la valeur seuil de basse tension, la valeur par défaut de la valeur seuil de basse tension est inférieure à une limite de tension inférieure de la plage de limite de sécurité ;
si la valeur de réglage seuil est la valeur seuil de surintensité, la valeur par défaut de la valeur seuil de surintensité est supérieure à une limite de courant supérieure de la plage de limite de sécurité ;
si la valeur de réglage seuil est la valeur seuil de surtempérature, la valeur par défaut de la valeur seuil de surtempérature est supérieure à une limite de température supérieure de la plage de limite de sécurité.

9. Dispositif de commande selon une quelconque revendication précédente, dans lequel :
la fonction de protection inclut une fonction d'ouverture d'un interrupteur (12) connecté entre l'au moins un module de batterie (11) et une charge (20) du système de batterie (10).

10. Système de batterie comprenant :
au moins un module de batterie (11) ; et
un dispositif de commande de batterie (14) selon une quelconque revendication 1 à 9.

11. Procédé de commande d'un système de batterie (10) incluant au moins un module de batterie (11), comprenant :
la réception d'une demande de changement d'une valeur de réglage seuil d'un paramètre lié à un état de l'au moins un module de batterie ;
la détermination si une valeur de changement de la valeur de réglage seuil est hors d'une plage de limite de sécurité prédéterminée ;
si la valeur de changement est au sein de la plage de limite de sécurité, le changement de la valeur de réglage seuil vers la valeur de changement ;
si la valeur de changement est hors de la plage de limite de sécurité, la limitation du changement de la valeur de réglage seuil ; et
la commande d'un fonctionnement d'une fonction de protection du système de batterie sur la base de la valeur de réglage seuil.

12. Procédé de commande selon la revendication 11, dans lequel :
la limitation inclut :
maintenir la valeur de réglage seuil comme valeur précédente si la valeur de changement est hors de la plage limite de sécurité, ou
le changement de la valeur de réglage seuil vers une valeur correspondant à la plage de limite de sécurité si la valeur de changement est hors de la plage de limite de sécurité.

13. Procédé de commande selon la revendication 11 ou 12, comprenant en outre :
la réception d'une demande de changement vers un mode de test, et
le changement d'un mode de fonctionnement du système de batterie (10) vers le mode de test, dans lequel le changement de la valeur de réglage seuil est autorisé uniquement pendant que le système de batterie fonctionne en mode de test.

14. Procédé de commande selon la revendication 11, 12 ou 13, comprenant en outre :
le changement du mode de fonctionnement du système de batterie (10) vers un mode normal si la connexion entre le système de batterie et un dispositif de test (40) est déconnectée ou si la fin du mode de test est demandée, et
le changement de la valeur de réglage seuil vers une valeur par défaut si le mode de fonctionnement du système de batterie est changé vers le mode normal,
dans lequel la valeur par défaut est une valeur à l'extérieur de la plage limite de sécurité.

15. Procédé de commande selon la revendication 14, dans lequel :
le paramètre est une tension de cellule, une tension de module, un courant ou une température de l'au moins un module de batterie (11) ;
la valeur de réglage seuil est une valeur seuil de surtension, une valeur seuil de basse tension, une valeur seuil de surintensité ou une valeur seuil de surtempérature de l'au moins un module de batterie ;
si la valeur de réglage seuil est la valeur seuil de surtension, la valeur par défaut de la valeur seuil de surtension est supérieure à une limite de tension supérieure de la plage de limite de sécurité ;
si la valeur de réglage seuil est la valeur seuil de basse tension, la valeur par défaut de la valeur seuil de basse tension est inférieure à une limite de tension inférieure de la plage de limite de sécurité ;
si la valeur de réglage seuil est la valeur seuil de surintensité, la valeur par défaut de la valeur seuil de surintensité est supérieure à une limite de courant supérieure de la plage de limite de sécurité ; et
si la valeur de réglage seuil est la valeur seuil de surtempérature, la valeur par défaut de la valeur seuil de surtempérature est supérieure à une limite de température supérieure de la plage de limite de sécurité.
